# EUROPEAN PATENT SPECIFICATION

(11) **EP 4 382 925 B1**
(45) Date of publication and mention of the grant of the patent: **13.05.2026**
(21) Application number: 22852664.6
(22) Date of filing: 07.06.2022
(51) Int. Cl.: G01R 31/12, G01R 31/00, G01R 31/58

(54) **PARTIAL DISCHARGE DETERMINATION DEVICE AND METHOD**
VORRICHTUNG UND VERFAHREN ZUR BESTIMMUNG VON TEILENTLADUNGEN
DISPOSITIF ET PROCÉDÉ DE DÉTERMINATION DE DÉCHARGE PARTIELLE

(30) Priority: 06.08.2021 JP 2021130134
(43) Date of publication of application: 12.06.2024
(73) Proprietor: Hitachi, Ltd., Tokyo 100-8280 (JP)
(72) Inventor: YAMADA, Hiromichi, Tokyo 100-8280 (JP); ONOE, Shinsuke, Tokyo 100-8280 (JP); KIDO, Mitsuyasu, Tokyo 100-8280 (JP)
(74) Representative: MERH-IP Matias Erny Reichl Hoffmann Patentanwälte PartG mbB
(86) International application number: PCT/JP2022/022933
(87) International publication number: WO 2023/013236

(56) References cited:
- WO-A1-2016/042675
- JP-A- 2020 012 726
- JP-A- 2020 012 726
- JP-A- 2021 038 927
- JP-A- H06 213 958
- JP-A- H07 234 257
- JP-A- H11 258 296
- US-A1- 2016 116 520
- HAO L ET AL: "Partial discharge source discrimination using a support vector machine", IEEE TRANSACTIONS ON DIELECTRICS AND ELECTRICAL INSULATION, IEEE SERVICE CENTER, PISCATAWAY, NJ, US, vol. 17, no. 1, 1 February 2010 (2010-02-01), pages 189 - 197, XP011302823, ISSN: 1070-9878
- VIGNESHWARAN B ET AL: "Partial discharge pattern analysis using multi-class support vector machine to estimate cavity size and position in solid insulation", SOFT COMPUTING, SPRINGER BERLIN HEIDELBERG, BERLIN/HEIDELBERG, vol. 24, no. 14, 27 November 2019 (2019-11-27), pages 10645 - 10656, XP037171571, ISSN: 1432-7643, [retrieved on 20191127], DOI: 10.1007/S00500-019-04570-7
- BASHARAN VIGNESHWARAN ET AL: "Recognition of multiple partial discharge patterns by multi-class support vector machine using fractal image processing technique", IET SCIENCE, MEASUREMENT AND TECHNOLOGY, THE INSTITUTION OF ENGINEERING AND TECHNOLOGY, MICHAEL FARADAY HOUSE, SIX HILLS WAY, STEVENAGE, HERTS. SG1 2AY, UK, vol. 12, no. 8, 1 November 2018 (2018-11-01), pages 1031 - 1038, XP006070186, ISSN: 1751-8822, DOI: 10.1049/IET-SMT.2018.5020

## Description

### Technical Field

The present invention relates to a partial discharge determination apparatus and a partial discharge determination method, and is suitably applied to, for example, a partial discharge determination apparatus that determines insulation degradation of an underground power transmission cable.

### Background Art

In an urban area, a huge power transmission network is laid in the ground, and power generated in a power plant is transmitted to each power consumer via the power transmission network. Since underground power transmission facilities have increased in the high economic growth period, and many of them are now 40 years old from the start of operation, a technology for diagnosing aging degradation has become important. A main factor of aging degradation of a cable is degradation of an insulator used for the cable.

As one of degradation diagnosis technologies for the underground power transmission cable, there is a partial discharge measurement method. The underground power transmission cable has a structure in which a conductor through which a current flows is covered with an insulator. In a case where a void is generated in the insulator due to aging degradation, partial discharge occurs in the void, and finally insulation breakdown occurs. In the partial discharge measurement method, such a partial discharge is observed, and the degree of insulation degradation of the underground power transmission cable is diagnosed based on the observation result, and various companies and research organizations have conducted studies to elucidate a partial discharge generation mechanism and estimate the degree of insulation degradation from partial discharge characteristics.

For example, NPL 1 describes a degradation diagnosis estimation method to which a result of measuring a phase angle characteristic of a partial discharge pulse from the start of voltage application to insulation breakdown using an experimental electrode, and a pattern recognition method are applied. Here, the phase angle characteristic of the partial discharge pulse is defined as a characteristic of the number n of partial discharge pulses with a charge amount q generated at a phase angle φ of a cable application voltage, and is also referred to as a φ-q-n characteristic.

In this literature, changes in φ-q-n characteristic in five time zones from the start of voltage application to insulation breakdown are illustrated. For example, immediately after voltage application, a positive partial discharge pulse is generated in a phase angle range of -30° to 90°, and a negative partial discharge pulse is generated in a phase angle range of 150° to 270°. A discharge charge amount is distributed from 10 pC to 400 pC for the positive pulse, and is distributed from -10 pC to -800 pC for the negative pulse. This causes a change in phase angle range and discharge charge amount range over time. In the degradation estimation method, the φ-q-n characteristic is generated from measurement data, and similarity comparison with a standard pattern corresponding to each of degree of degradations of a plurality of stages created in advance is performed.

In addition, NPL 2 discloses modeling of a state of degradation of an oil-filled (OF) cable in which bubbles are generated in an oil gap defect, design electric fields from 66 or 77 kV to 275 kV, measurement of a partial discharge characteristic under a hydraulic condition within an actual operation range, and an analysis result. Among them, it is described that a range of 100 pC or less is excluded as base noise removal in measurement of partial discharge by a digital oscilloscope.

Further, PTL 1 discloses a partial discharge detection system that performs machine learning on a signal generated during a predetermined period from the start of operation of an electric device to determine whether or not partial discharge has occurred in the electric device based on a learning model that learns a signal including noise near the electric device and a signal generated after the predetermined period has elapsed.

### Citation List

### Patent Literature

PTL 1: JP 2020-12726 A

### Non-Patent Literatures

NPL 1: Fumitaka Komori and three others, "Insulation degradation Diagnosis and Remaining Life Estimation Using Pattern Recognition by Partial Discharge Occurrence Phase Angle Distribution", The Institute of Electrical Engineers of Japan, 1993, Vol. 113-A, No. 8, p. 586-593
NPL 2: Yuta Makino, "Influence of Hydraulic Pressure and Electric Field on Partial Discharge Characteristic in OF Cable Oil-Impregnated Paper_Insulating Oil-Impregnated Insulation System Including Oil Film Defect", Report of Central Research Institute of Electric Power Industry, H15107, 2016

### Summary of Invention

### Technical Problem

Since a power cable and an electric device are exposed to environmental noise, it is considered that noise is mixed in a measured signal. In the φ-q-n (phase-charge amount-pulse number) characteristic of random noise, it is considered that the positive and negative pulses are substantially evenly distributed from 0 pC to the maximum positive and negative values, respectively, in all phase angle ranges of an applied voltage. The φ-q-n characteristic of a signal in which the random noise is mixed in the partial discharge pulse is considered to be a characteristic in which the φ-q-n characteristics of the partial discharge pulse and the random noise are superimposed.

Therefore, the standard pattern for similarity comparison with the φ-q-n characteristic of measurement data is appropriately set to three types of φ-q-n characteristics such as only partial discharge, only noise, and partial discharge with noise. In a case where an amplitude of the partial discharge pulse in the measurement data is sufficiently higher than an amplitude of the noise, there is a high probability of being determined as partial discharge. However, in a case where the amplitude of the partial discharge pulse is lower than the amplitude of the noise, there is a high probability of being determined as noise.

Therefore, a method of attenuating a noise component of a measured signal through a band-pass filter and extracting a partial discharge pulse component is considered, focusing on a difference in frequency characteristic between the partial discharge pulse and the noise. According to this method, although the noise cannot be completely removed, the amplitude of the noise can be reduced with respect to the amplitude of the partial discharge pulse.

As a result of actually measuring and analyzing data from a power cable using a partial discharge determination apparatus, the charge amount is minus (-) several hundreds of pC to several hundreds of pC in all phase angle ranges in a case where a filter is not inserted, but in a case where the band-pass filter is inserted and the measurement is performed, a phase angle characteristic of partial discharge can be observed.

However, with this method, the noise component cannot be completely removed and is measured as a signal in a range of minus (-) several tens of pC to several tens of pC lower than the amplitude of the partial discharge pulse, and the number thereof is many orders of magnitude larger than the number of partial discharge pulses, and thus, it has been found that there is a problem that it is determined as noise in similarity determination with the standard pattern.

The present invention has been made in view of the above points, and an object of the present invention is to propose a highly reliable partial discharge determination apparatus and method capable of accurately performing partial discharge determination based on measurement data acquired under a noise environment.

### Solution to Problem

In order to solve such a problem, in the present invention, a partial discharge determination apparatus that determines whether or not partial discharge has occurred in a power transmission facility includes: a partial discharge measurement unit that acquires measurement data representing a charge amount and a phase of each partial discharge occurring in the power transmission facility; a noise processing unit that removes or reduces noise included in the measurement data based on statistical information; a φ-q-n data generation unit that generates φ-q-n data representing a charge amount, a phase, and the number of pulses of the partial discharge and the noise included in the measurement data from the measurement data from which the noise has been removed or reduced by the noise processing unit; a learning model generation unit that generates a learning model by performing machine learning using the φ-q-n data of the partial discharge and the noise; and a determination unit that determines whether or not at least the partial discharge has occurred by using the learning model based on the φ-q-n data generated by the φ-q-n data generation unit.

Further, in the present invention, there is provided a partial discharge determination method executed in a partial discharge determination apparatus that determines whether or not partial discharge has occurred in a power transmission facility, the partial discharge determination method including: a first step of acquiring measurement data representing a charge amount and a phase of each partial discharge occurring in the power transmission facility; a second step of removing or reducing noise included in the measurement data based on statistical information; a third step of generating φ-q-n data representing a charge amount, a phase, and the number of pulses of the partial discharge and the noise included in the measurement data from the measurement data from which the noise has been removed or reduced; and a fourth step of determining whether or not at least the partial discharge has occurred by using a learning model generated by performing machine learning using the φ-q-n data of the partial discharge and the noise based on the φ-q-n data generated by a φ-q-n data generation unit.

With the partial discharge determination apparatus and the partial discharge determination method of the present invention, it is possible to accurately perform partial discharge determination based on measurement data acquired under a noise environment.

### Advantageous Effects of Invention

According to the present invention, a highly reliable partial determination apparatus and method can be implemented.

### Brief Description of Drawings

[FIG. 1] FIG. 1 is a block diagram illustrating an overall configuration of an underground power transmission cable degradation determination system.
[FIG. 2] FIG. 2 is a block diagram illustrating a detailed configuration of a partial discharge measurement apparatus.
[FIG. 3] FIG. 3 is a block diagram illustrating a schematic hardware configuration of the partial discharge determination apparatus.
[FIG. 4] FIG. 4 is a block diagram illustrating a flow of a series of processing in the underground power transmission cable degradation determination system.
[FIG. 5] FIGS. 5(A) to 5(D) are diagrams illustrating a relationship between a partial discharge pulse included in a partial discharge pulse signal and an applied voltage signal.
[FIG. 6] FIG. 6 is a table for describing φ-q data.
[FIG. 7] FIGS. 7(A) to 7(C) are diagrams illustrating partial discharge charge amount phase angle distribution patterns at the start of partial discharge, at the middle of partial discharge, or immediately before insulation breakdown, respectively.
[FIG. 8] FIG. 8 is a diagram illustrating a charge amount phase angle distribution pattern of φ-q-n data.
[FIG. 9] FIG. 9 is a diagram for describing normalization of the partial discharge charge amount phase angle distribution pattern.
[FIG. 10] FIG. 10 is a diagram illustrating a partial discharge charge amount phase angle distribution pattern obtained by normalizing the partial discharge charge amount phase angle distribution pattern in FIG. 9.
[FIG. 11] FIGS. 11(A) to 11(C) are diagrams illustrating partial discharge charge amount phase angle distribution patterns obtained by normalizing FIGS. 7(A) to 7(C), respectively.
[FIG. 12] FIGS. 12(A) to 12(C) are diagrams illustrating charge amount phase angle distribution patterns of learning φ-q-n data for partial discharge, noise, and partial discharge with noise, respectively.
[FIG. 13] FIGS. 13(A) to 13(D) are diagrams illustrating a relationship between a partial discharge pulse and noise included in the partial discharge pulse signal, and the applied voltage signal.
[FIG. 14] FIGS. 14(A) to 14(C) are diagrams illustrating the charge amount phase angle distribution patterns at the start of partial discharge, at the middle of partial discharge, or immediately before insulation breakdown of the partial discharge pulse signal including noise.
[FIG. 15] FIG. 15 is a diagram illustrating the charge amount phase angle distribution pattern of the φ-q-n data including noise.
[FIG. 16] FIG. 16 is a diagram illustrating the charge amount phase angle distribution pattern of the φ-q-n data for determination including noise.
[FIG. 17] FIG. 17 is a block diagram illustrating a flow of a series of processing in a noise reduction unit.
[FIG. 18] FIG. 18 is a graph illustrating frequency distribution of a charge amount generated by a charge distribution generation unit.
[FIG. 19] FIGS. 19(A) to 19 C) are diagrams illustrating the charge amount phase angle distribution patterns at the start of partial discharge, at the middle of partial discharge, or immediately before insulation breakdown of noise-reduced φ-q data output from the noise reduction unit.
[FIG. 20] FIG. 20 is a diagram illustrating the charge amount phase angle distribution pattern of visual recognition φ-q-n data generated from noise-reduced φ-q data of FIG. 19(A).
[FIG. 21] FIG. 21 is a diagram illustrating the charge amount phase angle distribution pattern of determination φ-q-n data generated from the φ-q-n data of FIG. 20.

### Description of Embodiments

Hereinafter, an embodiment of the present invention will be described in detail with reference to the drawings.

### (1) Configuration of Underground Power Transmission Cable Degradation Determination System According to Present Embodiment

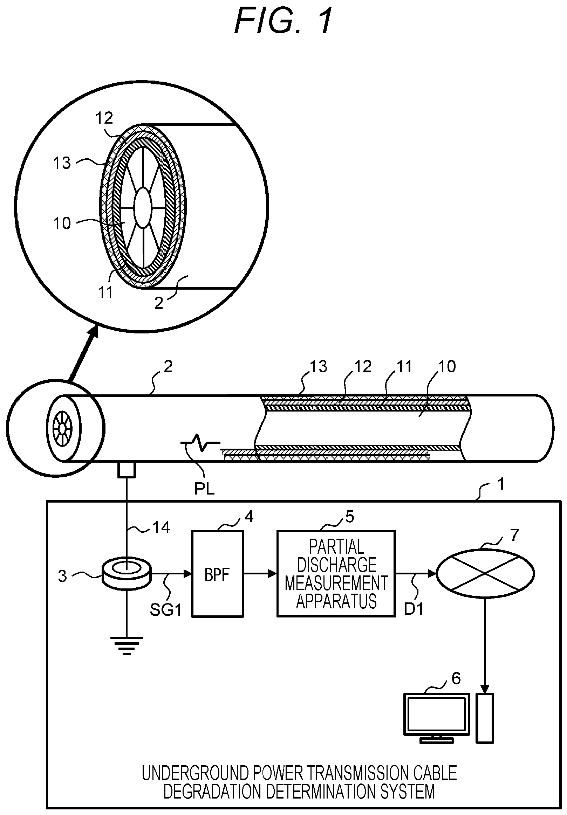

In FIG. 1, Reference Sign 1 denotes an underground power transmission cable degradation determination system to which the present invention is applied as a whole. The underground power transmission cable degradation determination system 1 is a system that monitors insulation degradation of an underground power transmission cable 2 by determining a progress degree of partial discharge occurring in the underground power transmission cable 2, and includes a divided radio frequency current transformer (CT) 3, a band-pass filter 4, a partial discharge measurement apparatus 5, and a partial discharge determination apparatus 6.

In a case of an oil-filled (OF) cable that maintains insulation with kraft paper and oil, the underground power transmission cable 2 is configured by sequentially stacking an insulator 11 formed of kraft paper impregnated with insulating oil, a metal sheath 12 for enclosing oil, and an anticorrosion layer 13 for corrosion prevention on a conductor 10 through which electricity flows. The metal sheath 12 is grounded via a metal sheath ground line 14, so that a partial discharge pulse PL generated in the underground power transmission cable 2 can be released to the ground via the metal sheath ground line 14.

The divided radio frequency CT 3 is implemented by a clamp type radio frequency current sensor, and is installed for each predetermined length of the underground power transmission cable 2. The divided radio frequency CT 3 generates a partial discharge pulse signal SG1 including the partial discharge pulse PL flowing through the metal sheath ground line 14, and transmits the generated partial discharge pulse signal SG1 to the band-pass filter 4.

The band-pass filter 4 passes only a signal component of several tens of MHz to several hundreds of MHz, which is a frequency band of the partial discharge pulse signal SG1, among signal components of various frequency bands included in the partial discharge pulse signal SG1 provided from the divided radio frequency CT 3, and outputs the signal component to the partial discharge measurement apparatus 5. By weakening a signal intensity of noise in a frequency band other than the necessary frequency band by using the band-pass filter 4 in this manner, the partial discharge pulse signal SG1 can be easily detected even in a case where noise such as broadcast waves are mixed in the signal flowing through the metal sheath ground line 14.

The partial discharge measurement apparatus 5 is installed corresponding to each divided radio frequency CT 3. The partial discharge measurement apparatus 5 measures a charge amount of each partial discharge pulse PL included in the partial discharge pulse signal SG1 transmitted from the corresponding divided radio frequency CT 3 and a phase angle of a voltage (hereinafter, referred to as an applied voltage) of electricity flowing through the underground power transmission cable 2 as a target (hereinafter, referred to as a target underground power transmission cable) at each time point when each partial discharge pulse PL is generated, and transmits the measurement result as measurement data D1 to the partial discharge determination apparatus 6 via a network 7.

The partial discharge determination apparatus 6 determines the progress degree of the partial discharge occurring in the target underground power transmission cable 2 based on the measurement data D1 transmitted from each partial discharge measurement apparatus 5, and displays the determination result.

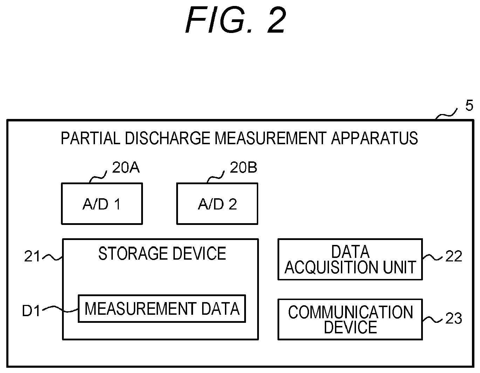

Here, FIG. 2 illustrates a schematic hardware configuration of the partial discharge measurement apparatus 5. As illustrated in FIG. 2, the partial discharge measurement apparatus 5 includes first and second analog/digital (A/D) converters 20A and 20B, a storage device 21, a data acquisition unit 22, and a communication device 23.

Each of the first and second A/D converters 20A and 20B is implemented by a general-purpose A/D converter. The storage device 21 is implemented by a hard disk device, a solid state drive (SSD), a semiconductor memory, or the like. The storage device 21 stores the measurement data D1 including data of the charge amount and the phase angle of each partial discharge pulse PL obtained by measurement.

The data acquisition unit 22 will be described later. The data acquisition unit 22 may have a software configuration. The communication device 23 is implemented by a network interface card (NIC) or the like, and performs protocol control when the partial discharge measurement apparatus 5 communicates with the partial discharge determination apparatus 6 via the network 7.

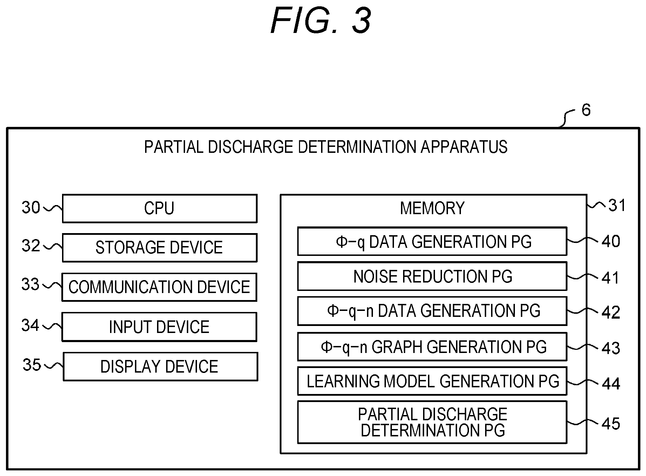

FIG. 3 illustrates a schematic hardware configuration of the partial discharge determination apparatus 6. As is clear from FIG. 2, the partial discharge determination apparatus 6 is implemented by a general-purpose computer device including a central processing unit (CPU) 30, a memory 31, a storage device 32, a communication device 33, an input device 34, and a display device 35.

The CPU 30 is a processor that controls the entire operation of the partial discharge determination apparatus 6. The memory 31 is implemented by a volatile semiconductor memory or the like, and is used as a work memory of the CPU 30. A φ-q data generation program 40, a noise reduction program 41, a φ-q-n data generation program 42, a φ-q-n graph generation program 43, a learning model generation program 44, and a partial discharge determination program 45 to be described later are loaded from the storage device 32 when the partial discharge determination apparatus 6 is started or when necessary, and stored and held in the memory 31.

The storage device 32 is implemented by a nonvolatile large-capacity storage device such as a hard disk device, an SSD, or a flash memory, and stores various programs, data to be held for a long period, and the like. The communication device 33 is implemented by an NIC or the like, and performs protocol control when the partial discharge determination apparatus 6 communicates with the partial discharge measurement apparatus 5 via the network 7.

The input device 34 is a device used when a user inputs a necessary command or information to the partial discharge determination apparatus 6, and is implemented by, for example, a keyboard, a mouse, or the like. Furthermore, the display device 35 is a device for displaying necessary information, and is implemented by, for example, a liquid crystal panel, an organic electro luminescence (EL) panel, or the like.

### (2) Flow of Partial Discharge Determination Processing in Underground Power Transmission Cable Degradation Determination System

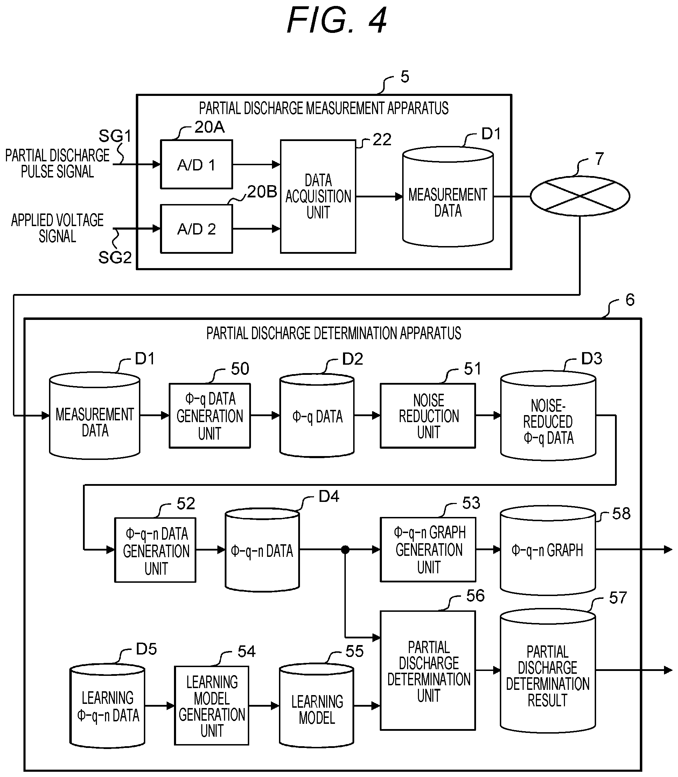

FIG. 4 illustrates a flow of a series of processing for determining the progress degree of the partial discharge occurring in the target underground power transmission cable 2 (hereinafter, referred to as partial discharge determination processing), which is executed in the underground power transmission cable degradation determination system 1. In the drawing, a φ-q data generation unit 50, a noise reduction unit 51, a φ-q-n data generation unit 52, a φ-q-n graph generation unit 53, a learning model generation unit 54, and a partial discharge determination unit 56 are functional units embodied by the CPU 30 executing corresponding programs among the φ-q data generation program 40, the noise reduction program 41, the φ-q-n data generation program 42, the φ-q-n graph generation program 43, the learning model generation program 44, and the partial discharge determination program 45 described above with reference to FIG. 3, the programs being loaded from the storage device 32 (FIG. 3) to the memory 31 (FIG. 3) in the partial discharge determination apparatus 6.

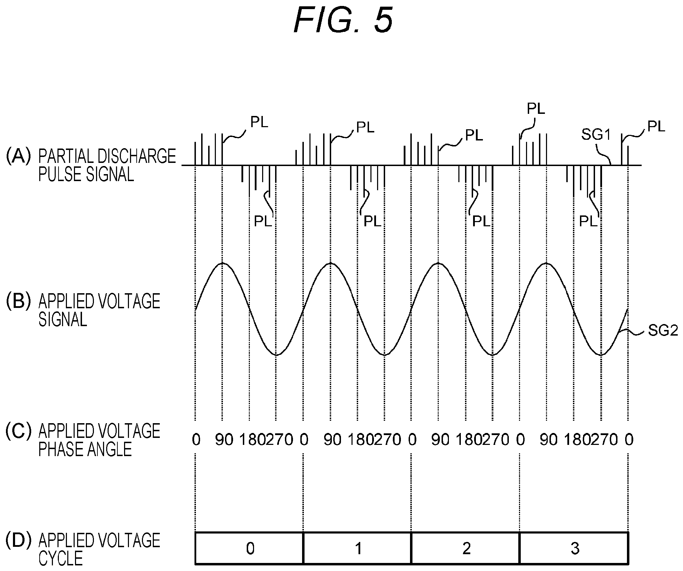

As illustrated in FIG. 4, in the underground power transmission cable degradation determination system 1, the partial discharge pulse signal SG1 as illustrated in FIG. 5(A), which is output from the divided radio frequency CT 3 (FIG. 1) and subjected to filtering processing in the band-pass filter 4, is provided to the first A/D converter 20A of the partial discharge measurement apparatus 5. Then, the first A/D converter 20A performs A/D conversion on the partial discharge pulse signal SG1, and outputs digital data of the partial discharge pulse signal SG1 thus obtained to the data acquisition unit 22.

An applied voltage signal SG2 as illustrated in FIG. 5(B) obtained by stepping down the applied voltage of the target underground power transmission cable 2 to about 5 V is provided to the second A/D converter 20B of the partial discharge measurement apparatus 5. The second A/D converter 20B performs A/D conversion on the applied voltage signal SG2, and outputs digital data of the applied voltage signal SG2 thus obtained to the data acquisition unit 22.

As is clear from FIGS. 5(A) to 5(D), in the partial discharge pulse signal SG1, the positive partial discharge pulse PL is generated near a zero-crossing point where the applied voltage changes from negative to positive, and the negative partial discharge pulse PL is generated near a zero-crossing point where the applied voltage changes from positive to negative.

The data acquisition unit 22 extracts each partial discharge pulse PL included in the partial discharge pulse signal SG1, and acquires a digital value of a voltage value of each partial discharge pulse PL as the charge amount of the partial discharge pulse PL. The data acquisition unit 22 acquires, for each partial discharge pulse PL, a phase angle (hereinafter, referred to as a phase angle or a generation phase angle of the partial discharge pulse PL) of the applied voltage signal SG2 at a time point when the partial discharge pulse PL is generated. Then, the data acquisition unit 22 stores a set of the charge amount and the phase angle of each partial discharge pulse PL acquired in this manner in the storage device 21 (FIG. 2) as the measurement data D1.

Thereafter, the measurement data D1 stored in the storage device 21 is read by the partial discharge determination apparatus 6 via the network 7 and stored in the storage device 32 (FIG. 3). Thereafter, the measurement data D1 stored in the storage device 32 is read by the φ-q data generation unit 50.

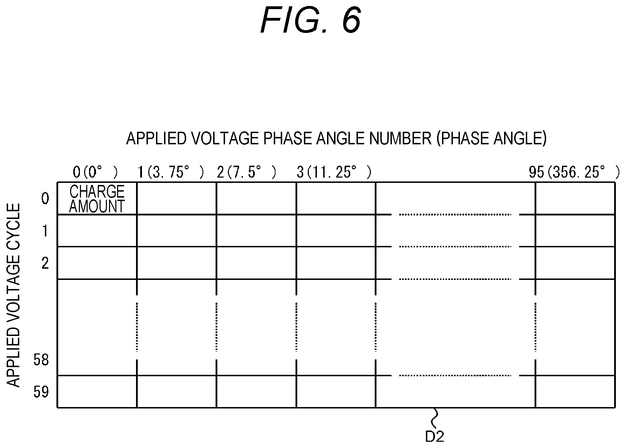

The φ-q data generation unit 50 generates φ-q data D2 as illustrated in FIG. 6 in which a charge amount q of an applied voltage phase φ is represented for each applied voltage cycle based on the read measurement data D1. As illustrated in FIG. 6, the φ-q data D2 is two-dimensional array data in which the horizontal axis represents an applied voltage phase angle number and the vertical axis represents the applied voltage cycle. The applied voltage phase angle number is an integer from 0 to 95, and means a phase angle in increments of 3.75° from 0° to 356.25°. There are 60 applied voltage cycles from 0 to 59. Therefore, for example, when the applied voltage of the target underground power transmission cable 2 is 60 Hz, the φ-q data D2 is generated every one second. The maximum charge amount among the measured charge amounts of the corresponding partial discharge pulses PL (or noise) is stored at an intersection of the applied voltage phase angle number and the applied voltage cycle. Then, the φ-q data generation unit 50 outputs the generated φ-q data D2 to the noise reduction unit 51.

The noise reduction unit 51 generates noise-reduced φ-q data D3 in which a noise component is reduced based on statistical information from the φ-q data D2 provided from the φ-q data generation unit 50, and outputs the generated noise-reduced φ-q data D3 to the φ-q-n data generation unit 52. A specific configuration and processing contents of the noise reduction unit 51 will be described later.

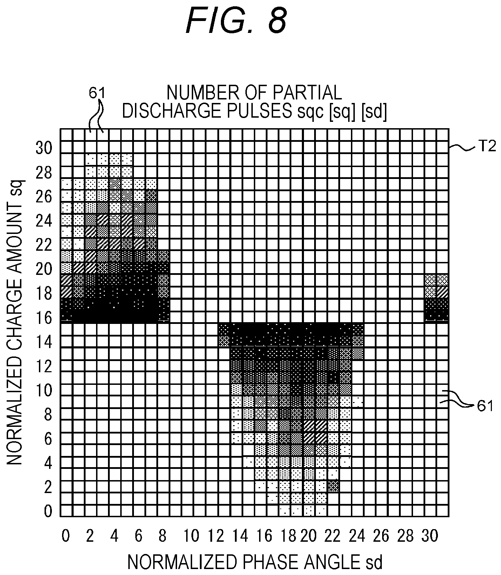

The φ-q-n data generation unit 52 generates φ-q-n data D4 to be described later with reference to FIG. 8 based on the noise-reduced φ-q data D3 provided from the noise reduction unit 51. The φ-q-n data D4 is data representing characteristics of the partial discharge pulse PL with the charge amount q generated at the phase angle φ and the number n of pulses of noise on two-dimensional coordinates. Then, the φ-q-n data generation unit 52 outputs the generated φ-q-n data D4 to the φ-q-n graph generation unit 53 and the partial discharge determination unit 56.

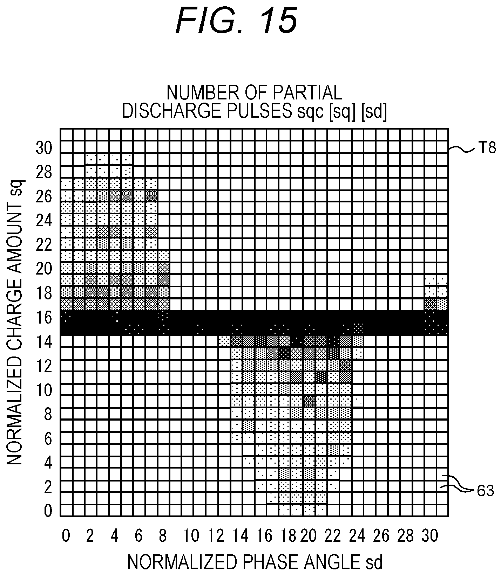

The φ-q-n graph generation unit 53 generates a φ-q-n graph 58 to be described later with respect to FIG. 15 in which the φ-q-n data D4 provided from the φ-q-n data generation unit 52 is graphed. Then, the φ-q-n graph 58 thus generated is displayed on the display device 35 (FIG. 3) .

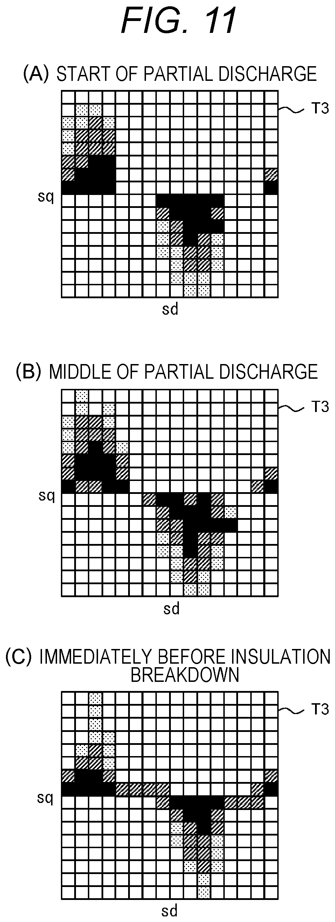

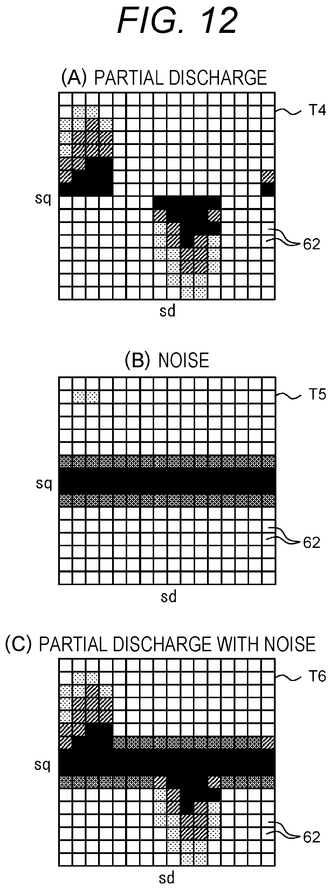

Meanwhile, a plurality of pieces of φ-q-n data for each degree of degradation (that is the progress degree of partial discharge, and the same applies hereinafter) of the underground power transmission cable 2 generated by degradation simulation of the underground power transmission cable 2 using a computer, for example, as will be described later with reference to FIGS. 11(A) to 11(C), and respective pieces of data of the partial discharge pulse, the noise, and the partial discharge pulse with noise generated by simulation using the computer, as will be described later with reference to FIGS. 12(A) to 12(C) are provided as learning φ-q-n data D5 to the learning model generation unit 54. Then, by using the learning φ-q-n data D5, the learning model generation unit 54 performs machine learning using a phase angle distribution pattern of the charge amount of the partial discharge pulse PL, a phase angle distribution pattern of the noise, and a phase angle distribution pattern of the charge amount of the partial discharge pulse PL with noise for each degree of degradation of the underground power transmission cable 2, and generates a learning model 55 as a learning result.

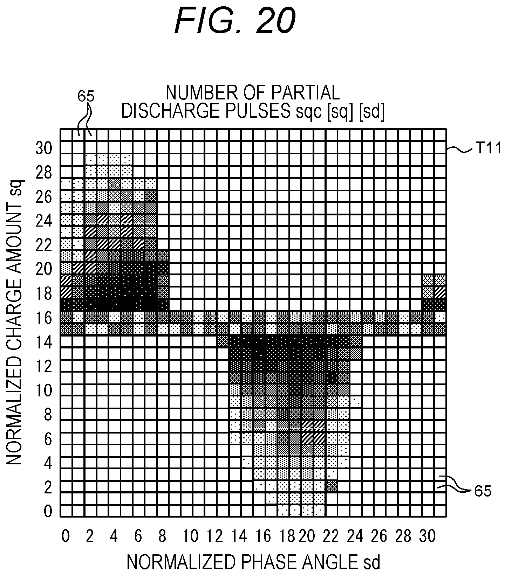

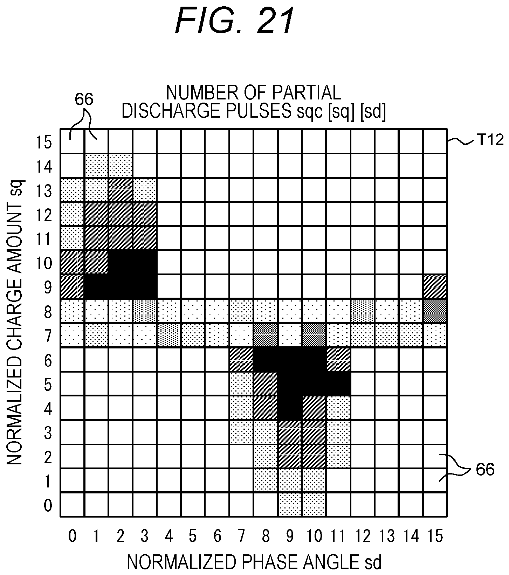

Then, the partial discharge determination unit 56 generates φ-q-n data for determination (hereinafter, referred to as determination φ-q-n data) to be described later with reference to FIG. 20 based on, for example, the φ-q-n data D4 to be described later with reference to FIG. 21 provided from the φ-q-n data generation unit 52, and determines whether or not the partial discharge pulse PL has been generated by inputting the generated determination φ-q-n data to the learning model 55, and determines the degree of degradation (the progress degree of the partial discharge) of the target underground power transmission cable 2 in a case where the partial discharge pulse PL has been generated. Then, the partial discharge determination unit 56 displays the determination result of such determination on the display device 35 (FIG. 3) in a predetermined format as a partial discharge determination result 57.

### (3) Specific Processing Contents of Functional Units of Partial Discharge Determination Apparatus

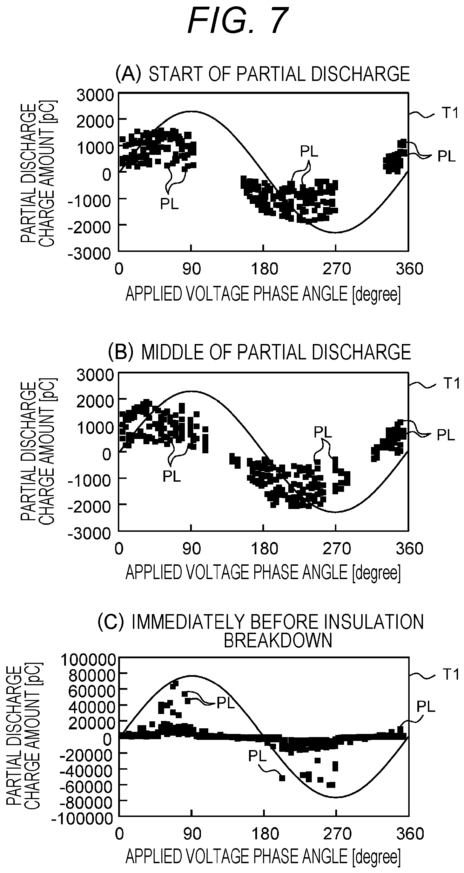

Here, FIGS. 7(A) to 7(C) illustrate examples of the phase angle distribution pattern of the charge amount of the partial discharge pulse PL obtained by plotting points representing the respective partial discharge pulses PL generated in a plurality of cycles (for example, 60 cycles) of the applied voltage on a coordinate plane in which the vertical axis represents the charge amount of the partial discharge pulse PL and the horizontal axis represents the phase angle of the applied voltage. FIGS. 7(A) to 7(C) illustrate examples of a case where there is no noise, and "■" in the drawings corresponds to the partial discharge pulse PL. Hereinafter, such a pattern is referred to as a charge amount phase angle distribution pattern T1.

FIG. 7(A) illustrates an example of the charge amount phase angle distribution pattern T1 of the partial discharge pulse PL at the start of the partial discharge. In this example, the positive partial discharge pulse PL is generated near the zero-crossing point where the applied voltage changes from negative to positive, and the negative partial discharge pulse PL is generated near the zero-crossing point where the applied voltage changes from positive to negative. Specifically, FIG. 7(A) illustrates that the partial discharge pulse PL having a positive charge amount is generated in a range in which the phase angle of the applied voltage is 0 to 90 degrees, the partial discharge pulse PL having a negative charge amount is generated in a range in which the phase angle of the applied voltage is 150 to 270 degrees, and the partial discharge pulse PL having a positive charge amount is generated in a range in which the phase angle of the applied voltage is 330 to 360 degrees.

FIG. 7(B) illustrates an example of the charge amount phase angle distribution pattern T1 of the partial discharge at the middle of the partial discharge. At the middle of the partial discharge, the charge amount of the partial discharge pulse PL increases as compared with the charge amount phase angle distribution pattern T1 of FIG. 7A, and a range of the phase angle in which the partial discharge pulse PL is generated also increases.

FIG. 7(C) illustrates an example of the charge amount phase angle distribution pattern T1 of the partial discharge immediately before insulation breakdown in the later stage of the partial discharge. FIG. 7(C) illustrates that the partial discharge pulse PL is generated at all phase angles of the applied voltage, and the charge amount thereof ranges from plus (+) several tens of thousands of pC to minus (-) several tens of thousands of pC.

As described above, the charge amount and the generation phase angle of the partial discharge pulse PL gradually change from the start of the partial discharge to immediately before the insulation breakdown. Specifically, as the degradation of the underground power transmission cable 2 due to the partial discharge progresses, the number of places where the partial discharge occurs increases as described above, and the charge amount of the partial discharge also increases.

FIG. 8 illustrates a charge amount phase angle distribution pattern T2 of the φ-q-n data D4 (FIG. 4) obtained by normalizing the charge amount phase angle distribution pattern T1 of the partial discharge illustrated in FIG. 7(A). The φ-q-n data generation unit 52 (FIG. 4) normalizes the φ-q data (noise-reduced φ-q data D3) in which the noise is reduced by the noise reduction unit 51 (FIG. 4), and generates the φ-q-n data D4 in such a way as to count the number of occurrences of partial discharge for each combination of a normalized charge amount and a normalized phase angle.

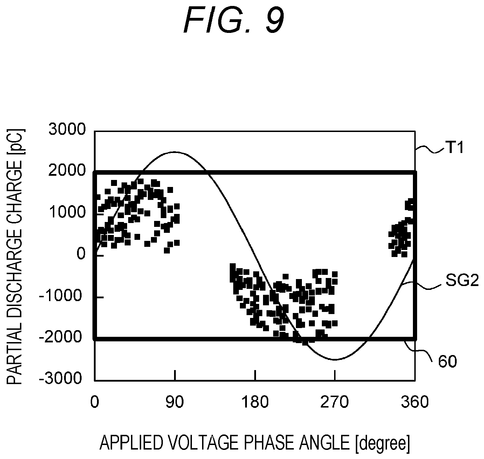

Specifically, as illustrated in FIG. 9, the φ-q-n data generation unit 52 first sets a range (hereinafter, referred to as a window) 60 including all the points representing the partial discharge pulse PL in FIG. 7(A) on the charge amount phase angle distribution pattern T1. At this time, a vertical length of the window 60 representing a discharge charge amount of the partial discharge is set in such a way that the charge amount from 0 to the top and the charge amount from 0 to the bottom are the same. That is, an absolute value of a larger one of a positive maximum value and a negative maximum value of the partial discharge charge amount is the length from 0 to the top and the length from 0 to the bottom of the window 60.

Next, the φ-q-n data generation unit 52 divides each of a longitudinal direction and a lateral direction of the window 60 of FIG. 9 into a predetermined number of equal parts, divides the inside of the window 60 into a plurality of small regions (hereinafter, referred to as cells) 61 as illustrated in FIG. 8, and sets a counter (hereinafter, referred to as a partial discharge pulse counter) for counting the number of partial discharge pulses PL (and noise pulses) corresponding to each cell 61.

FIG. 8 illustrates an example in which the window 60 is divided into 32 equal parts in both the longitudinal direction and the lateral direction. In the vertical direction of FIG. 8, one cell 61 represents a normalized charge amount sq. In FIG. 9, since the range of the window 60 in the longitudinal direction is -2000 pC to +2000 pC, in FIG. 8, sq = 0 corresponds to a range of -2000 pC or more and less than -1875 pC, and sq = 1 corresponds to a range of -1875 pC or more and less than -1750 pC. The same applies to sq = 2 to sq = 14. sq = 15 corresponds to a range of - 125 pC or more and less than 0 pC, sq = 16 corresponds to a range of more than 0 pC and 125 pC or less, and sq = 17 corresponds to a range of more than 125 pC and 250 pC or less. The same applies to sq = 18 to sq = 30. sq = 31 corresponds to a range of more than 1875 pC and 2000 pC or less.

In the lateral direction of FIG. 8, one cell 61 represents one normalized phase angle sd. As described above, since the normalized phase angle sd is obtained by dividing the applied voltage phase angle into 32 equal parts, the increment of the normalized phase angle sd is 11.25 degrees. sd = 0 corresponds to a range of 0 degrees or more and less than 11.25 degrees, and sd = 1 corresponds to a range of 11.25 degrees or more and less than 22.5 degrees. The same applies to sd = 2 to sd = 31.

Next, the φ-q-n data generation unit 52 normalizes the charge amount of each target partial discharge pulse PL (and noise pulse) to an integer value of 0 to 31. Further, the φ-q-n data generation unit 52 counts up the partial discharge pulse counter of the cell 61 corresponding to a combination of the normalized charge amount and the normalized phase angle generated by the φ-q-n data generation unit 52 for each partial discharge pulse PL (and noise pulse). As a result, the number sqc of corresponding partial discharge pulses PL (hereinafter, referred to as the number of partial discharge pulses) is counted for each cell 61.

In FIG. 8, for easy understanding, each cell 61 is colored at a density corresponding to the number sqc of partial discharge pulses counted by the partial discharge pulse counter of the cell 61. Specifically, in FIG. 8, a cell 61 with no color indicates that the number sqc of normalized partial discharge pulses is 0, and each cell 61 is colored in such a way that the density becomes higher in order of light gray, dark gray, and black as the number sqc of normalized partial discharge pulses increases.

Then, the φ-q-n data generation unit 52 outputs the number sqc of partial discharge pulses of each cell 61 counted as described above to the φ-q-n graph generation unit 53 (FIG. 4) and the partial discharge determination unit 56 (FIG. 4) as the φ-q-n data D4.

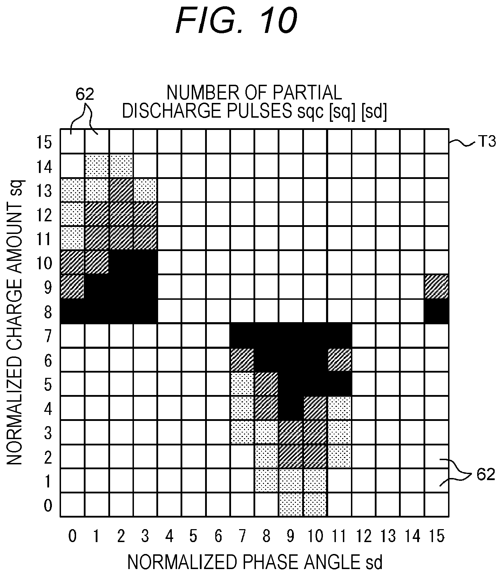

Meanwhile, FIG. 10 illustrates an example of a charge amount phase angle distribution pattern T3 of the φ-q-n data of the partial discharge pulse PL in the learning φ-q-n data D5 provided to the learning model generation unit 54. The learning φ-q-n data D5 includes information regarding the number of partial discharge pulses of each cell 61 in the charge amount phase angle distribution pattern T3 having 16 cells 62 in each of the lateral direction and the longitudinal direction, in which the total number sqc of partial discharge pulses of four (2 × 2) cells 61 in the charge amount phase angle distribution pattern T2 of the φ-q-n data D4 is set as the number of partial discharge pulses of one cell 62 combining the four cells 62. The resolution of the learning φ-q-n data D5 is set to 1/4 of the resolution of the φ-q-n data D4 in order to speed up learning processing and determination processing to be described later.

FIGS. 11(A) to 11(C) illustrate the charge amount phase angle distribution patterns T3 of the learning φ-q-n data D5 generated based on, for example, the φ-q-n data having the charge amount phase angle distribution pattern T1 of each of FIGS. 7(A) to 7(C) generated by the degradation simulation. FIG. 11(A) illustrates the charge amount phase angle distribution pattern T3 of the learning φ-q-n data D5 at the start of the partial discharge, FIG. 11(B) illustrates the charge amount phase angle distribution pattern T3 of the learning φ-q-n data D5 at the middle of the partial discharge, and FIG. 11(C) illustrates the charge amount phase angle distribution pattern T3 of the learning φ-q-n data D5 immediately before the insulation breakdown. As the φ-q-n data, practically, not only three stages of the start of the partial discharge, the middle of the partial discharge, and immediately before the insulation breakdown, but also the φ-q-n data for each finer degree of degradation is provided to the learning model generation unit 54 as learning data.

FIGS. 12(A) to 12(C) illustrate charge amount phase angle distribution patterns T4 to T6 of partial discharge, noise, and partial discharge with noise provided to the learning model generation unit 54 as the learning φ-q-n data D5. FIG. 12(A) illustrates the charge amount phase angle distribution pattern T4 of the learning φ-q-n data D5 for the partial discharge, which is the same as FIG. 11(A). In addition, FIG. 12(B) illustrates the charge amount phase angle distribution pattern T5 of the learning φ-q-n data D5 for the noise simulating the random noise, the charge amount phase angle distribution pattern T5 being a band-shaped pattern in a range of all the normalized phase angles sd. FIG. 12(C) illustrates the charge amount phase angle distribution pattern T6 of the learning φ-q-n data D5 for the partial discharge with noise, the charge amount phase angle distribution pattern T6 being generated by adding up the values of the corresponding cells 62 in FIGS. 12(A) and 12(B) .

The learning model generation unit 54 generates the learning model 55 by learning the charge amount phase angle distribution pattern T3 for each degree of degradation of the underground power transmission cable 2 based on the φ-q-n data having the charge amount phase angle distribution patterns T3 as illustrated in FIGS. 11(A) to 11(C) and performing machine learning using the charge amount phase angle distribution patterns for the noise or the partial discharge with noise as illustrated in FIGS. 12(A) to 12(C).

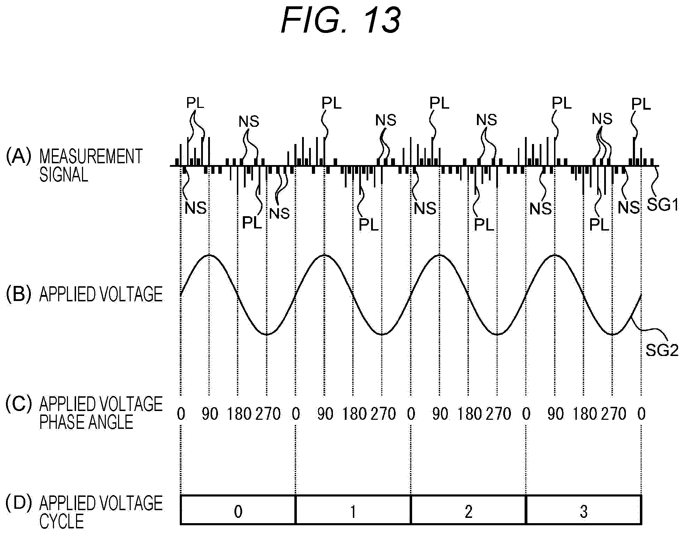

FIG. 13 illustrates a relationship between the applied voltage signal SG2 and the partial discharge pulse PL and noise NS included in the partial discharge pulse signal SG1. As is clear from FIG. 13, in the partial discharge pulse signal SG1, the positive partial discharge pulse PL is generated near a zero-crossing point where the applied voltage changes from negative to positive, and the negative partial discharge pulse PL is generated near a zero-crossing point where the applied voltage changes from positive to negative. On the other hand, in the noise NS, positive and negative pulses are randomly generated in all phase ranges of the applied voltage.

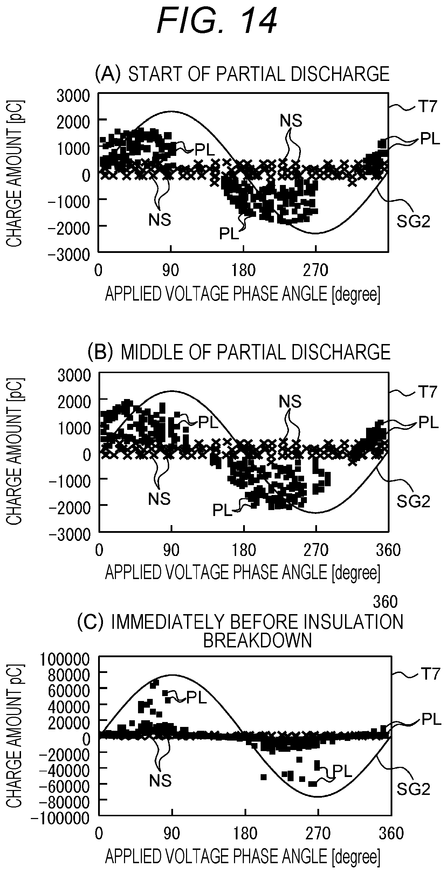

FIGS. 14(A) to 14(C) illustrate examples of a charge amount phase angle distribution pattern T7 of the partial discharge pulse signal SG1 in which the partial discharge pulse PL and the noise NS are mixed. The charge amount phase angle distribution patterns T7 illustrated in FIGS. 14(A) to 14(C) can be generated by generating the φ-q data D2 described above with reference to FIG. 6 from the partial discharge pulse signal SG1 illustrated in FIG. 13(A) and plotting the value of the generated φ-q data D2 on a coordinate plane in which the horizontal axis represents the applied voltage phase angle and the vertical axis represents the charge amount. In the drawing, "**■**" corresponds to the partial discharge pulse, and "×" corresponds to the noise.

FIG. 14(A) illustrates the charge amount phase angle distribution pattern T7 based on the φ-q data D2 at the start of the partial discharge. As is clear from FIG. 14(A), in the φ-q data D2 at the start of the partial discharge, a positive partial discharge pulse PL is generated in a range of the applied voltage phase angle of 0° to 90°, a negative partial discharge pulse PL is generated in a range of the applied voltage phase angle of 150° to 270°, and a positive partial discharge pulse PL is generated in a range of the applied voltage phase angle of 330° to 360°. In addition, the noise NS occurs in all the phase angle ranges.

FIG. 14(B) illustrates the charge amount phase angle distribution pattern T7 based on the φ-q data D2 at the middle of the partial discharge. At the middle of the partial discharge, a change appears in the charge amount and the generation phase angle of the partial discharge pulse PL from the charge amount phase angle distribution pattern T7 of FIG. 14(A), but since there is a charge of the noise NS, it is difficult to identify a difference between the charge amount phase angle distribution pattern T7 at the middle of the partial discharge and the charge amount phase angle distribution pattern T7 at the start of the partial discharge of FIG. 13(A).

FIG. 14(C) illustrates the charge amount phase angle distribution pattern T7 based on the φ-q data D2 immediately before the insulation breakdown. As illustrated in FIG. 14(C), immediately before the insulation breakdown, charges of several tens of thousands of pC and charges of minus several tens of thousands of pC are generated.

FIG. 15 illustrates a charge amount phase angle distribution pattern T8 of the φ-q-n data generated from the φ-q data D2 of a signal in which the partial discharge pulse PL and the noise NS described above with reference to FIG. 14(A) are mixed. Similarly to FIG. 8, the vertical axis in FIG. 15 represents the normalized charge amount sq obtained by dividing the range of -2000 pC to +2000 pC in FIG. 14(A) into 32 equal parts. Unlike the charge amount phase angle distribution pattern T2 of the φ-q-n data D4 of only the partial discharge pulse PL in FIG. 8, it can be seen that cells 63 of which the normalized charge amount sq is in a range of 0 to 14 and cells 63 of which the normalized charge amount sq is in a range of 17 to 31 have lighter colors, while cells 63 of which the normalized charge amount sq is in a range of 15 to 16 has darker colors. This is because the charge amounts of the partial discharge pulse PL and the noise NS in FIG. 14(A) are concentrated at small values around 0 pC.

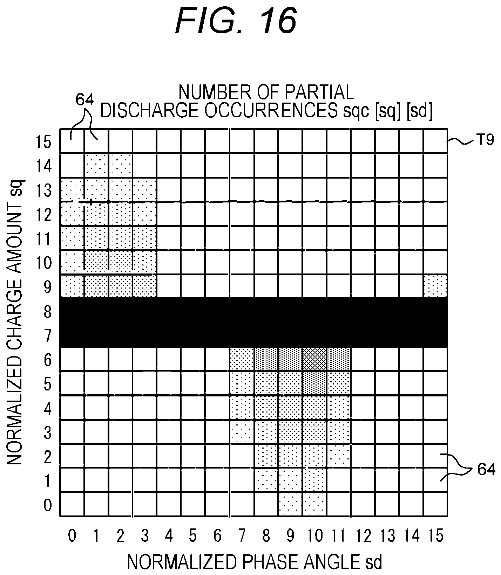

FIG. 16 illustrates a charge amount phase angle distribution pattern T9 of the determination φ-q-n data generated by the partial discharge determination unit 56 based on the φ-q-n data having the charge amount phase angle distribution pattern T8 illustrated in FIG. 15, for example. In the determination φ-q-n data, similarly to FIG. 10, the normalized charge amount sq and the normalized phase angle sd are each divided into 16 equal parts, and the total values of the partial discharge pulses PL and the noises NS of four (2 × 2) adjacent cells 63 (FIG. 15) in the φ-q-n data are set as the values of the partial discharge pulse PL and the noise NS of one corresponding cell 64.

In the charge amount phase angle distribution pattern T9 of the determination φ-q-n data, the cells 64 of which the normalized charge amount sq is in a range of 0 to 6 and the cells of which the normalized charge amount sq is in a range of 9 to 15 have lighter colors, and the cells of which the normalized charge amount sq is in a range of 7 and 8 have darker colors, unlike the charge amount phase angle distribution pattern T3 of the learning φ-q-n data D5 in FIG. 10. When the determination φ-q-n data is determined using the learning model 55 (FIG. 4) obtained by learning the learning φ-q-n data D5 illustrated in FIGS. 12(A) to 12(C), a probability of being determined as noise increases.

As described above, in a case where the φ-q data D2 of the signal in which the partial discharge pulse PL and the noise NS are mixed is used as it is to generate the φ-q-n data without passing through the noise reduction unit 51, the determination φ-q-n data is generated based on the generated φ-q-n data, and the partial discharge determination is performed, correct determination cannot be performed.

Therefore, in the partial discharge determination apparatus 6 of the present embodiment, the above-described disadvantage is eliminated by reducing the noise component included in the φ-q data D2 in the noise reduction unit 51 as described above, and thus, the partial discharge determination unit 56 can perform determination with high accuracy.

### (4) Detailed Configuration of Noise Reduction Unit

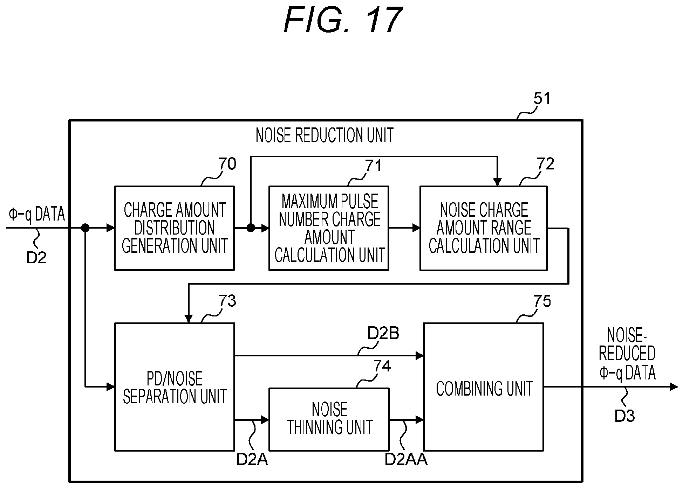

Next, a detailed configuration of the noise reduction unit 51 described above with reference to FIG. 4 will be described. FIG. 17 illustrates a flow of a series of processing in the noise reduction unit 51. In the present embodiment, the noise NS is specified using the characteristic of the noise NS that the charge amount is smaller than the charge amount of the partial discharge pulse PL and is concentrated in a specific charge amount range, and the noise NS is reduced from the φ-q data D2 by separating the φ-q data D2 into the partial discharge pulse PL and the noise NS.

A charge amount distribution generation unit 70, a maximum pulse number charge amount calculation unit 71, a noise charge amount range calculation unit 72, a partial discharge (PD)/noise separation unit 73, a noise thinning unit 74, and a combining unit 75 in FIG. 17 are functional units implemented by the CPU 30 of the partial discharge determination apparatus 6 described above with reference to FIG. 3 executing the noise reduction program 41 stored in the memory 31.

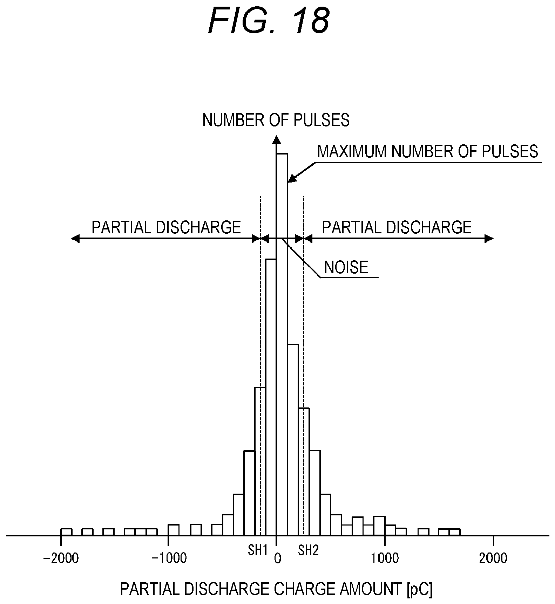

The charge amount distribution generation unit 70 generates frequency distribution of the charge amount of the pulse (the partial discharge pulse PL and the noise NS) included in the φ-q data D2 as described later with reference to FIG. 18 based on the φ-q data D2 provided from the φ-q data generation unit 50 (FIG. 5). Here, such a frequency of the charge amount of the pulse is calculated for each of ranges obtained by dividing the charge amount range including a negative maximum value to a positive maximum value into about several tens of equal parts. For example, in a case where the negative maximum value of the charge amount is - 2000 pC and the positive maximum value is +2000 pC, and a range from -2000 pC to +2000 pC is divided into 40 equal parts, the charge amount distribution generation unit 70 counts the number of charge amounts in each of the ranges of -2000 to -1900, -1900 to -1800, ..., - 100 to 0, 0 to +100,..., and +1900 to +2000, and generates the frequency distribution of the charge amount based on the count result. Then, the charge amount distribution generation unit 70 outputs the generated frequency distribution of the charge amount to the maximum pulse number charge amount calculation unit 71 and the noise charge amount range calculation unit 72 as charge amount distribution information.

Based on the charge amount distribution information provided from the charge amount distribution generation unit 70, the maximum pulse number charge amount calculation unit 71 calculates a charge amount at which the frequency of the charge amount is maximum (a charge amount estimated to have the maximum number of pulses is hereinafter referred to as a maximum pulse number charge amount), and outputs the calculated charge amount to the noise charge amount range calculation unit 72 as maximum pulse number charge amount information. For example, in a case where the frequency of the charge amount range of 0 to 100 pC is maximum as illustrated in FIG. 18, 50 pC which is an average value of the range may be set as the maximum pulse number charge amount. Alternatively, the number of charge amounts in each of the ranges of 0 to 10 pC, 10 to 20 pC,..., and 90 to 100 pC obtained by further dividing the charge amount of 0 to 100 pC by 10 is calculated, and an average value of the charge amount range of which the number is maximum may be set as the maximum pulse number charge amount.

The noise charge amount range calculation unit 72 calculates a threshold of the charge amount (a range of the charge amount of the noise) for separating the partial discharge pulse PL and the noise NS based on the charge amount distribution information provided from the charge amount distribution generation unit 70 and the maximum pulse number charge amount information provided from the maximum pulse number charge amount calculation unit 71.

Specifically, the noise charge amount range calculation unit 72 sorts the charge amounts in ascending or descending order of frequency based on the charge amount distribution information, and calculates a range of the charge amount including a predetermined proportion of the total number of pulses in directions of the negative charge amount and the positive charge amount with the maximum pulse number charge amount notified from the maximum pulse number charge amount calculation unit 71 as the center (for example, a range described as "noise" in FIG. 18). In the present embodiment, 90% based on the statistical information is applied as the predetermined proportion. The charge amounts on both sides of this range are set to the thresholds for separating the partial discharge pulse PL and the noise NS (hereinafter, referred to as charge amount thresholds SH1 and SH2 (see FIG. 18)).

That is, the charge amount from the minimum value of the charge amount to the smaller charge amount threshold SH1 is the partial discharge pulse, the charge amount between the two charge amount thresholds SH1 and SH2 is the noise NS, and the charge amount from the larger charge amount threshold SH2 to the maximum charge amount is the partial discharge pulse PL. Then, the noise charge amount range calculation unit 72 outputs the two charge amount thresholds SH1 and SH2 calculated in this manner to the PD/noise separation unit 73.

Based on the two charge amount thresholds SH1 and SH2 provided from the noise charge amount range calculation unit 72, the PD/noise separation unit 73 separates the φ-q data D2 provided from the φ-q data generation unit 50 (FIG. 4) into φ-q data (hereinafter, referred to as noise φ-q data) D2A of the noise NS and φ-q data (hereinafter, referred to as partial discharge φ-q data) D2B of the partial discharge pulse PL. Therefore, the partial discharge φ-q data D2B is φ-q data D2 in which the noise component is reduced. Then, the PD/noise separation unit 73 outputs the separated noise φ-q data D2A to the noise thinning unit 74, and outputs the partial discharge φ-q data D2B to the combining unit 75.

The noise thinning unit 74 executes thinning processing (thinning of noise data) on the noise φ-q data D2A provided from the PD/noise separation unit 73. For example, in a case where a predetermined proportion (hereinafter, 90%) of data of the noise φ-q data D2A is thinned to leave 10% of data, the noise thinning unit 74 generates a random number of 0 to 1 and leaves the original value in a case where the random number is 0 to 0.1, and replaces the original value with 0 in other cases. The reason why a part of the noise is left is that there is a partial discharge pulse PL having the same charge amount as the noise. Then, the noise thinning unit 74 outputs noise φ-q data (hereinafter, referred to as thinned noise φ-q data) D2AA obtained by thinning the data in this manner to the combining unit 75.

The combining unit 75 combines the thinned noise φ-q data D2AA provided from the noise thinning unit 74 and the partial discharge φ-q data D2B provided from the PD/noise separation unit 73, and outputs the φ-q data D2 obtained by reducing the noise component thus obtained to the φ-q-n data generation unit 52 (FIG. 4) as the noise-reduced φ-q data D3 described above.

FIG. 18 is a bar graph representing the frequency distribution of the charge amount generated by the charge amount distribution generation unit 70. In the drawing, the charge amount with the largest number of pulses (the highest in the bar graph) is the maximum pulse number charge amount, and 50 pC, which is an average value of 0 to 100 pC in FIG. 18, corresponds to the maximum pulse number charge amount. Further, in FIG. 18, two broken lines represent the above-described charge amount thresholds SH1 and SH2, respectively, and a charge amount in a range sandwiched between these two charge amount thresholds SH1 and SH2 is separated as the noise NS, and other charge amounts are separated as the partial discharge pulse PL by the PD/noise separation unit 73.

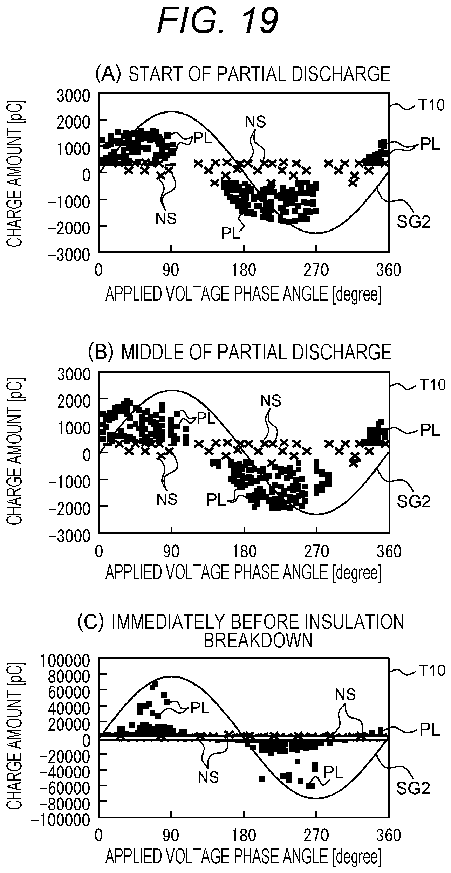

FIGS. 19(A) to 19(C) illustrate examples of a charge amount phase angle distribution pattern T10 of the noise-reduced φ-q data D3 output from the noise reduction unit 51. FIG. 19(A) illustrates the charge amount phase angle distribution pattern T10 of the noise-reduced φ-q data D3 at the start of the partial discharge, FIG. 19(B) illustrates the charge amount phase angle distribution pattern T10 of the noise-reduced φ-q data D3 at the middle stage of the partial discharge, and FIG. 19(C) illustrates the charge amount phase angle distribution pattern T10 of the noise-reduced φ-q data D3 immediately before the insulation breakdown. Comparing the charge amount phase angle distribution patterns T10 in FIGS. 19(A) to 19(C) with the charge amount phase angle distribution patterns T7 of the φ-q data D2 in which the partial discharge pulse PL and the noise NS described above with reference to FIGS. 14(A) to 14(C) are mixed, it can be seen that the noise NS is reduced in certain positive and negative charge amount ranges centered on 0 pC at the start of the partial discharge, at the middle of the partial discharge, and immediately before the insulation breakdown.

FIG. 20 illustrates an example of a charge amount phase angle distribution pattern T11 of the φ-q-n data D4 generated from the noise-reduced φ-q data D3 illustrated in FIG. 19(A). Similarly to FIG. 15, the vertical axis represents the normalized phase angle sd obtained by dividing -2000 pC to +2000 pC into 32 equal parts, and the horizontal axis represents the normalized phase angle sd obtained by dividing the applied voltage phase angle into 32 equal parts. Comparing the charge amount phase angle distribution pattern T8 of the φ-q-n data D4 in which the partial discharge pulse PL and the noise NS are mixed described above with reference to FIG. 15 with the charge amount phase angle distribution pattern T11 illustrated in FIG. 20, it can be seen that in the charge amount phase angle distribution pattern T11 illustrated in FIG. 20, the color of a cell 65 is darker in a range where the normalized charge amount sq is 0 to 14 and a range where the normalized charge amount sq is 17 to 31, and the color of the cell 65 is lighter in a range where the normalized charge amount sq is 15 to 16.

FIG. 21 illustrates a charge amount phase angle distribution pattern T12 of the φ-q-n data for determination generated by the partial discharge determination unit 56 based on the φ-q-n data D4 described above with reference to FIG. 20. In the determination φ-q-n data, similarly to FIG. 16, the normalized charge amount sq and the normalized phase angle sd are each set to 16, and the total value of four (2 × 2) adjacent cells 65 (FIG. 20) of the φ-q-n data D4 is set to a value of a cell 66.

Comparing the charge amount phase angle distribution pattern T9 of the determination φ-q-n data in which the partial discharge pulse PL and the noise NS are mixed in FIG. 16 with the charge amount phase angle distribution pattern T12 of the determination φ-q-n data in which the noise component is reduced in FIG. 18, it can be seen that, in the charge amount phase angle distribution pattern T12 of the determination φ-q-n data in which the noise component is reduced, the cells 66 of which the normalized charge amount sq is in a range of 0 to 6 and the cells 66 of which the normalized charge amount sq is in a range of 9 to 15 have darker colors, and the cells 66 of which the normalized charge amount sq is in a range of 7 and 8 has lighter colors.

Since the partial discharge determination unit 56 described above with reference to FIG. 4 determines the determination φ-q-n data D4 by using the learning model 55 (FIG. 4) subjected to machine learning using the learning φ-q-n data D4 described above with reference to FIG. 12, a probability of being determined as the partial discharge with noise increases.

### (5) Effects of Present Embodiment

As described above, in the partial discharge determination apparatus 6 of the present embodiment, the noise reduction unit 51 reduces the noise included in the φ-q data D2 based on the statistical information, generates the φ-q-n data D4 based on the φ-q data D2 in which the noise is reduced, and determines whether or not the partial discharge has occurred by using the learning model 55 obtained by machine learning using the learning φ-q-n data D5 based on the generated φ-q-n data D4, and the degree of degradation (the progress degree of the partial discharge) of the target underground power transmission cable 2 in a case where the partial discharge has occurred in the target underground power transmission cable 2. Therefore, with the partial discharge determination apparatus 6, partial discharge determination can be performed based on the measurement data acquired under a noise environment, and thus a highly reliable partial discharge determination apparatus can be implemented.

In addition, in the partial discharge determination apparatus 6, the noise reduction unit 51 separates the φ-q data D2 into the data of the partial discharge pulse PL and the data of the noise based on the statistical information with a predetermined range centered on the charge amount at which the frequency is maximum in the charge amount distribution of the φ-q data D2 as the noise to reduce the noise of the φ-q data D2. Therefore, it is possible to completely remove the noise component. Therefore, for example, when the noise component is removed using a band-pass filter or the like, a problem that the noise is measured as a signal in a range of minus (-) tens of pC to plus (+) tens of pC does not occur, and partial discharge determination can be performed with high reliability.

### (6) Other Embodiments

In the above embodiment, a case where the present invention is applied to the partial discharge determination apparatus 6 whose target of determination of the progress degree of the partial discharge is the underground power transmission cable 2 has been described. However, the present invention is not limited thereto, and can be widely applied to various partial discharge determination apparatuses that determine the progress degree of partial discharge occurring in a power transmission cable other than the underground power transmission cable 2 and other power transmission facilities.

In addition, in the above embodiment, a case where the φ-q-n data generated by the degradation simulation is applied as the learning φ-q-n data D5 has been described, but the present invention is not limited thereto, and for example, an actual measurement value of the φ-q-n data measured using the underground power transmission cable 2 having the degree of degradation of each stage under an environment in which noise does not occur may be applied as the learning φ-q-n data D5.

Furthermore, in the above embodiment, a case where the partial discharge determination apparatus 6, which is one computer device, has a function of executing a series of partial discharge determination processing described with reference to FIG. 4 has been described. However, the present invention is not limited thereto, and such a function may be divided into a plurality of functional parts, and these functional parts may be distributed and mounted on a plurality of computer devices included in a distributed computing system.

Furthermore, in the above embodiment, a case where the noise reduction unit 51 that reduces noise is applied as a noise processing unit that removes or reduces noise included in the measurement data based on the statistical information has been described, but the present invention is not limited thereto, and the noise reduction unit 51 may be constructed to completely remove noise. However, since the partial discharge pulse PL also exists in a charge amount band of the noise, it is possible to improve the accuracy of the partial discharge determination by reducing the noise instead of completely removing the noise as in the present embodiment.

### Industrial Applicability

The present invention can be widely applied to various partial discharge determination apparatuses that determine whether or not partial discharge has occurred in a power transmission facility and the progress degree of the partial discharge (the degree of degradation of the power transmission facility).

### Reference Signs List

1 underground power transmission cable degradation determination system
2 underground power transmission cable
3 divided radio frequency CT
4 band-pass filter
5 partial discharge measurement apparatus
6 partial discharge determination apparatus
30 CPU
35 display device
40 φ-q data generation program
41 noise reduction program
42 φ-q-n data generation program
44 learning model generation program
45 partial discharge determination program
50 φ-q data generation unit
51 noise reduction unit
52 φ-q-n data generation unit
54 learning model generation unit
55 learning model
56 partial discharge determination unit
61 to 66 cell
D1 measurement data
D2 φ-q data
D3 noise-reduced φ-q data
D4 φ-q-n data
D5 learning φ-q-n data
NS noise
PL partial discharge pulse
SG1 partial discharge pulse signal
SG2 applied voltage signal
T1 to T11 charge amount phase angle distribution pattern

## Claims

1. A partial discharge determination apparatus that determines partial discharge occurring in a power transmission facility, the partial discharge determination apparatus comprising:
a partial discharge measurement unit (5) that acquires measurement data representing a charge amount and a phase of each partial discharge occurring in the power transmission facility;
a noise processing unit (51) that removes or reduces noise included in the measurement data based on statistical information;
a φ-q-n data generation unit (52) that generates φ-q-n data representing a charge amount, a phase, and the number of pulses of each of the partial discharge and the noise included in the measurement data from the measurement data from which the noise has been removed or reduced by the noise processing unit;
a learning model generation unit (54) that generates a learning model by performing machine learning using the φ-q-n data of the partial discharge and the noise; and
a determination unit (56) that determines whether or not at least the partial discharge has occurred by using the learning model based on the φ-q-n data generated by the φ-q-n data generation unit.

2. The partial discharge determination apparatus according to claim 1, wherein the noise processing unit removes or reduces the noise from the measurement data by separating the measurement data into data of the partial discharge and data of the noise with a predetermined range centered on a charge amount at which a frequency is maximum in charge amount distribution of the measurement data as the noise.

3. The partial discharge determination apparatus according to claim 2, wherein the noise processing unit thins the separated data of the noise at a predetermined ratio, and combines the thinned data of the noise and the separated data of the partial discharge to remove or reduce the noise from the measurement data.

4. The partial discharge determination apparatus according to claim 1, wherein the determination unit determines a progress degree of the partial discharge in a case where the partial discharge has occurred.

5. A partial discharge determination method executed in a partial discharge determination apparatus that determines partial discharge occurring in a power transmission facility, the partial discharge determination method comprising:
a first step of acquiring measurement data representing a charge amount and a phase of each partial discharge occurring in the power transmission facility;
a second step of removing or reducing noise included in the measurement data based on statistical information;
a third step of generating φ-q-n data representing a charge amount, a phase, and the number of pulses of each of the partial discharge and the noise included in the measurement data from the measurement data from which the noise has been removed or reduced; and
a fourth step of determining whether or not at least the partial discharge has occurred by using a learning model generated by performing machine learning using the φ-q-n data of the partial discharge and the noise based on the φ-q-n data.

6. The partial discharge determination method according to claim 5, wherein in the second step, the noise is removed or reduced from the measurement data by separating the measurement data into data of the partial discharge and data of the noise with a predetermined range centered on a charge amount at which a frequency is maximum in charge amount distribution of the measurement data as the noise.

7. The partial discharge determination method according to claim 6, wherein in the second step, the separated data of the noise is thinned at a predetermined ratio, and the thinned data of the noise and the separated data of the partial discharge are combined to remove or reduce the noise from the measurement data.

8. The partial discharge determination method according to claim 5, wherein in the fourth step, a progress degree of the partial discharge is determined in a case where the partial discharge has occurred.

## Patentansprüche

1. Vorrichtung zur Bestimmung von Teilentladungen, die Teilentladungen bestimmt, die in einer Leistungsübertragungsanlage auftreten, wobei die Vorrichtung zur Bestimmung von Teilentladungen Folgendes umfasst:
eine Einheit (5) zur Messung einer Teilentladung, die Messdaten erfasst, die eine Ladungsmenge und eine Phase jeder Teilentladung, die in der Leistungsübertragungsanlage auftritt, darstellen;
eine Rauschverarbeitungseinheit (51), die Rauschen, das in den Messdaten enthalten ist, basierend auf statistischen Informationen entfernt oder verringert;
eine φ-q-n-Daten-Erzeugungseinheit (52), die φ-q-n-Daten, die eine Ladungsmenge, eine Phase und die Zahl von Impulsen jeder der Teilentladung und des Rauschens, das in den Messdaten enthalten ist, darstellen, aus den Messdaten erzeugt, in denen das Rauschen durch die Rauschverarbeitungseinheit entfernt oder verringert worden ist;
eine Lernmodell-Erzeugungseinheit (54), die durch das Durchführen von maschinellem Lernen unter Verwendung der φ-q-n-Daten der Teilentladung und des Rauschens ein Lernmodell erzeugt; und
eine Bestimmungseinheit (56), die basierend auf den φ-q-n-Daten, die durch die φ-q-n-Daten-Erzeugungseinheit erzeugt worden sind, unter Verwendung des Lernmodells bestimmt, ob zumindest die Teilentladung aufgetreten ist oder nicht.

2. Vorrichtung zur Bestimmung von Teilentladungen nach Anspruch 1, wobei die Rauschverarbeitungseinheit durch Trennen der Messdaten in Daten der Teilentladung und Daten des Rauschens das Rauschen in den Messdaten entfernt oder verringert, wobei das Rauschen durch einen vorgegebenen Bereich, der um eine Ladungsmenge zentriert ist, bei der eine Frequenz in der Ladungsmengenverteilung der Messdaten maximal ist, bestimmt wird.

3. Vorrichtung zur Bestimmung von Teilentladungen nach Anspruch 2, wobei die Rauschverarbeitungseinheit die abgetrennten Daten des Rauschens mit einem vorgegebenen Verhältnis ausdünnt, und die ausgedünnten Daten des Rauschens und die abgetrennten Daten der Teilentladung kombiniert, um das Rauschen in den Messdaten zu entfernen oder zu verringern.

4. Vorrichtung zur Bestimmung von Teilentladungen nach Anspruch 1, wobei die Bestimmungseinheit einen Fortschrittsgrad der Teilentladung in einem Fall, in dem die Teilentladung aufgetreten ist, bestimmt.

5. Verfahren zur Bestimmung einer Teilentladung, das in einer Vorrichtung zur Bestimmung von Teilentladungen ausgeführt wird, die Teilentladung bestimmt, die in einer Leistungsübertragungsanlage auftritt, wobei das Verfahren zur Bestimmung einer Teilentladung Folgendes umfasst:
einen ersten Schritt des Erfassens von Messdaten, die eine Ladungsmenge und eine Phase von jeder Teilentladung, die in der Leistungsübertragungsanlage auftritt, darstellen;
einen zweiten Schritt des Entfernens oder Verringerns von Rauschen, das in den Messdaten enthalten ist, basierend auf statistischen Informationen;
einen dritten Schritt des Erzeugens von φ-q-n-Daten, die eine Ladungsmenge, eine Phase und die Zahl der Impulse jeder der Teilentladungen und des Rauschens, das in den Messdaten enthalten ist, darstellen, aus den Messdaten, in denen das Rauschen entfernt oder verringert worden ist; und
einen vierten Schritt des Bestimmens, ob zumindest die Teilentladung aufgetreten ist oder nicht, unter Verwendung eines Lernmodells, das durch das Durchführen von maschinellem Lernen unter Verwendung der φ-q-n-Daten der Teilentladung und des Rauschens basierend auf den φ-q-n-Daten erzeugt wird.

6. Verfahren zur Bestimmung einer Teilentladung nach Anspruch 5, wobei in dem zweiten Schritt das Rauschen durch das Trennen der Messdaten in Daten der Teilentladung und Daten des Rauschens in den Messdaten entfernt oder verringert wird, wobei das Rauschen durch einen vorgegebenen Bereich, der um eine Ladungsmenge zentriert ist, bei der eine Frequenz in der Ladungsmengenverteilung der Messdaten maximal ist, bestimmt wird.

7. Verfahren zur Bestimmung einer Teilentladung nach Anspruch 6, wobei in dem zweiten Schritt die abgetrennten Daten des Rauschens mit einem vorgegebenen Verhältnis ausgedünnt werden, und die ausgedünnten Daten des Rauschens und die abgetrennten Daten der Teilentladung kombiniert werden, um das Rauschen aus den Messdaten zu entfernen oder zu verringern.

8. Verfahren zur Bestimmung einer Teilentladung nach Anspruch 5, wobei in dem vierten Schritt ein Fortschrittsgrad der Teilentladung in einem Fall bestimmt wird, in dem die Teilentladung aufgetreten ist.

## Revendications

1. Appareil de détermination de décharge partielle qui détermine une décharge partielle survenue dans une installation de transmission de puissance, l'appareil de détermination de décharge partielle comprenant :
une unité de mesurage de décharge partielle (5) qui acquiert des données de mesurage représentant une amplitude de charge et une phase de chaque décharge partielle survenue dans l'installation de transmission de puissance ;
une unité de traitement de bruit (51) qui élimine ou réduit un bruit inclus dans les données de mesurage sur la base d'informations statistiques ;
une unité de génération de données φ-q-n (52) qui génère des données φ-q-n représentant une amplitude de charge, une phase, et le nombre d'impulsions à la fois de la décharge partielle et du bruit inclus dans les données de mesurage parmi les données de mesurage à partir desquelles le bruit a été éliminé ou réduit par l'intermédiaire de l'unité de traitement de bruit ;
une unité de génération de modèle d'apprentissage (54) qui génère un modèle d'apprentissage en effectuant un apprentissage automatique à l'aide des données φ-q-n de la décharge partielle et du bruit ; et
une unité de détermination (56) qui détermine si oui ou non au moins la décharge partielle est survenue à l'aide du modèle d'apprentissage sur la base des données φ-q-n générées par l'unité de génération de données φ-q-n.

2. Appareil de détermination de décharge partielle selon la revendication 1, dans lequel l'unité de traitement de bruit élimine ou réduit le bruit parmi les données de mesurage en séparant les données de mesurage en données de la décharge partielle et en données du bruit avec une plage prédéterminée centrée sur une amplitude de charge à laquelle une fréquence est maximum dans une distribution d'amplitude de charge des données de mesurage à titre de bruit.

3. Appareil de détermination de décharge partielle selon la revendication 2, dans lequel l'unité de traitement de bruit allège les données séparées du bruit à un taux prédéterminé, et combine les données allégées du bruit et les données séparées de la décharge partielle pour éliminer ou réduire le bruit parmi les données de mesurage.

4. Appareil de détermination de décharge partielle selon la revendication 1, dans lequel l'unité de détermination détermine un degré de progression de la décharge partielle dans un cas où la décharge partielle est survenue.

5. Procédé de détermination de décharge partielle exécutée dans l'appareil de détermination de décharge partielle qui détermine une décharge partielle survenue dans une installation de transmission de puissance, le procédé de détermination de décharge partielle comprenant :
une première étape consistant à acquérir des données de mesurage représentant une amplitude de charge et une phase de chaque décharge partielle survenue dans l'installation de transmission de puissance ;
une deuxième étape consistant à éliminer ou à réduire un bruit inclus dans les données de mesurage sur la base d'informations statistiques ;
une troisième étape consistant à générer des données φ-q-n représentant une amplitude de charge, une phase, et le nombre d'impulsions à la fois de la décharge partielle et du bruit inclus dans les données de mesurage parmi les données de mesurage à partir desquelles le bruit a été éliminé ou réduit ; et
une quatrième étape consistant à déterminer si oui ou non au moins la décharge partielle est survenue en utilisant un modèle d'apprentissage généré en effectuant un apprentissage automatique à l'aide des données φ-q-n de la décharge partielle et du bruit sur la base des données φ-q-n.

6. Procédé de détermination de décharge partielle selon la revendication 5, dans lequel, dans la deuxième étape, le bruit est éliminé ou réduit parmi les données de mesurage en séparant les données de mesurage en données de la décharge partielle et en données du bruit avec une plage prédéterminée centrée sur une amplitude de charge à laquelle une fréquence est maximum dans une distribution d'amplitude de charge des données de mesurage à titre de bruit.

7. Procédé de détermination de décharge partielle selon la revendication 6, dans lequel, dans la deuxième étape, les données séparées du bruit sont allégées à un taux prédéterminé, et les données allégées du bruit et les données séparées de la décharge partielle sont combinées pour éliminer ou réduire le bruit parmi les données de mesurage.

8. Procédé de détermination de décharge partielle selon la revendication 5, dans lequel, dans la quatrième étape, un degré de progression de la décharge partielle est déterminé dans un cas où la décharge partielle est survenue.
